# EUROPEAN PATENT APPLICATION

(11) **EP 0 887 847 A1**
(43) Date of publication of application: **30.12.1998**
(21) Application number: 97830173.7
(22) Date of filing: 15.04.1997
(51) Int. Cl.: H01L 21/3105, H01L 21/98

(54) **Process of final passivation of integrated circuit devices**

(71) Applicant: STMicroelectronics S.r.l., 20041 Agrate Brianza (Milano) (IT)
(72) Inventor: De Santi, Giorgio, 20124 Milano (IT); Crisenza, Giuseppe, 20056 Trezzo Sull'Adda (Milano) (IT); Zanotti, Luca, 20041 Agrate Brianza (Milano) (IT)
(74) Representative: Mittler, Enrico

(57) **Abstract**

A process of final passivation of an integrated circuit device comprising at least one integrated circuit chip (3;3',3''), comprising a step of formation of a layer of protective material (5) over a top surface of the at least one integrated circuit, characterized by providing for a subsequent step of planarization of said layer of protective material (5) to obtain a protection layer having a substantially flat top surface.

## Description

The present invention relates to a process of final passivation of integrated circuit devices.

Semiconductor integrated circuits manufactured with Large Scale of Integration technologies (LSI, VLSI, ULSI) have to be covered by a protective layer against mechanical stress and aggressive chemical agents. This layer, generally called "final passivation layer", is typically formed by silicon-based dielectric materials, such as silicon dioxide (USG), phosphorus-doped or fluorurate-doped silicon oxide (PSG or FSG), silicon nitrides and nitride oxides (SiOₓN_{y}, Si₃N₄).

The final passivation layer is conventionally formed by means of Chemical Vapor Deposition (CVD) techniques, either plasma-enhanced (PECVD) or at atmosferic pressure (APCVD).

The top surface of the passivation layer formed by means of conventional techniques is not planar, having protrusions and depressions caused by gaps in the underlying layers (for example, gaps between metal lines of the uppermost metal interconnection layer). This is disadvantageous, because when the chip is encapsulated in a package the mechanical stress exerted by the latter on the chip is not uniformly distributed over the surface of the passivation layer. This can lead to cracks in the passivation layer, through which aggressive agents or water molecules can penetrate and reach the underlying layers of the chip.

According to the present invention, this problem is overcome by means of a process of final passivation of an integrated circuit device comprising at least one integrated circuit chip, comprising a step of formation of a layer of protective material over a top surface of the at least one integrated circuit, characterized by providing for a subsequent step of planarization of said layer of protective material to obtain a protection layer having a substantially flat top surface.

Preferably, said planarization step is performed by means of a Chemical Mechanical Polishing (CMP) technique. CMP is a technique already known in the field of integrated circuit manufacturing, being used to planarize inter-metal dielectric layers (i.e., dielectric layers provided between superimposed metal layers to electrically isolate one from the other).

Alternatively, said planarization step can be performed by means of a Reactive Ion Etching (RIE) technique, which is another technique already employed in the field of integrated circuit manufacturing for selectively removing layers of material.

The step of formation of the layer of protective material can involve a conventional chemical vapor deposition of a suitable material, either by means of plasma-enhanced CVD or CVD at atmosferic pressure.

In a preferred embodiment of the invention, the formation of the layer of protective material is performed by means of the so-called High-Density Plasma CVD (HDPCVD), a deposition technique known for some years for the formation of inter-metal dielectric layers in integrated circuits of very small geometries. The use of HDPCVD for forming the layer of protective material (final passivation layer), constituting the object of a co-pending patent application in the name of the same Applicant, allows for a better filling of gaps in the layers underlying the passivation layer.

The provision of a planarization step of the layer of protective material is particularly advantageous in the case of multi chip devices, comprising two or more distinct chips encapsulated in a same package. In this case, according to the prior art, not only the passivation layer of each chip would have depressions and protrusions, but the top surface of the passivation layers of the different chips would normally be at different heights, due to the fact that each chip would normally have a different thickness. The process of the present invention, providing for a planarization step of the layer of protective material covering the multi chip device, allows for having the top surface of the final passivation layer of the different chips at the same height.

The features of the present invention will be made more evident by the following detailed description of some particular embodiments thereof, illustrated as non-limiting examples in the annexed drawings, wherein:
Figure 1 is a schematic cross-sectional view of an integrated circuit chip after a final passivation layer has been formed thereupon;
Figure 2 is a schematic cross-section of the integrated circuit chip of Figure 1 after the final passivation layer has been planarized, according to the process of the invention;
Figure 3 is a schematic cross-section of a multi chip device, with a final passivation layer formed by means of the process of the present invention.

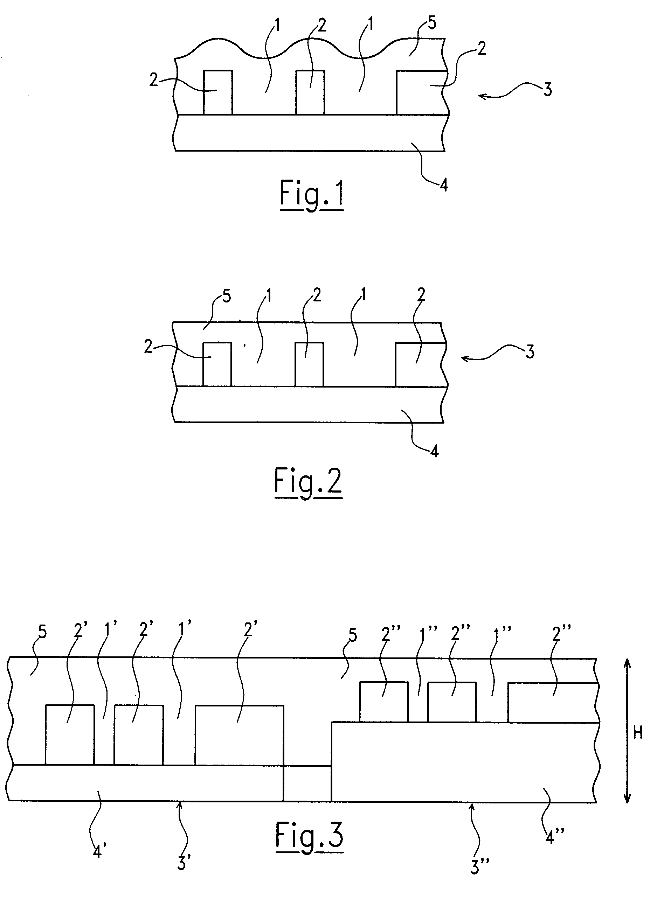

In Figure 1 a portion of an integrated circuit chip 3 is schematically shown in cross-section; the chip generically comprises a substrate 4, over which e.g. metal lines 2 are formed; between the metal lines 2, gaps 1 are formed. The chip is covered by a final passivation layer 5 of a protective material. Suitable materials conventionally used in the integrated circuit manufacturing industry for final passivation layers include silicon dioxide (USG), phosphorus-doped or fluorurate-doped silicon oxide (PSG or FSG), silicon nitrides and nitride oxides (SiOₓN_{y}, Si₃N₄); conventionally the passivation layer is formed by means of a Chemical Vapor Deposition (CVD) technique, either Plasma-Enhanced (PECVD) or at Atmosferic Pressure (APCVD).

The above-referred conventional techniques of formation of the passivation layer are suitable for integrated circuits with geometries not extremely small; if the scale of integration is increased, and the gaps 1 become as narrow as 0.8 µm, a so-called "Dep(osition)-Etch(ing)-Dep(osition)" technique is preferably used to form the passivation layer. This technique provides for a first deposition of only a part of the total thickness of the passivation layer, for example by means of PECVD, follwed by an isotropic neutral ion sputter-etch (typically argon), and then an additional PECVD deposition to fill the gaps 1.

If the scale of integration is increased further, so that the gaps 1 become narrower than e.g. 0.5 µm, conventional PECVD, APCVD and Dep-Etch-Dep techniques do not allow for the passivation layer 5 to completely fill the said gaps. In this case it is preferred another deposition technique, known as HDPCVD, already known in the integrated circuit manufacturing industry for the formation of inter-metal dielectric thin films. HDPCVD can be advantageously used for forming the passivation layer, allowing for a better filling of the gaps. The passivation layer could also be formed by a stack of layers, the lowermost formed by means of HDPCVD technique, and the superimposed layers formed by conventional PECVD or APCVD techniques. The application of HDPCVD to the formation of final passivation layers forms the object of a co-pending European patent application in the name of the same Applicant.

As visible from Figure 1, after the layer of protective material 5 has been deposited, the top surface thereof is not at all planar, having depressions and protrusions caused by the presence of gaps in the underlying layers, in this example the metal lines 2.

According to the present invention, after a protection layer 5, preferably of thickness at least equal to approximately 2 µm, has been deposited over the chip, it is submitted to a planarization process to eliminate the protrusions and depressions from its top surface.

Such a planarization process can for example comprise a Chemical Mechanical Polishing (CMP) process.

The semiconductor wafer to which the integrated circuit belong is mounted with its front surface in contact with a pad and the rear surface with a rotary head. The rotary motion of the head, together with the pressure of the head which biasses the wafer into contact with the pad, and the action of an abrasive powder ("slurry"), allow to remove a total protection layer thickness ranging from 0.3 to 0.8 µm. Typically, the head pressure is in the range 1-4 PSI, and the rotation speed is in the range 40-80 rpm; a slurry of PH of approximately 9.5 to 11.5 is used, and it is supplied at a flow rate of 100-300 ml/min. The resulting polishing rate varies between 200 to 700 nm/min, so that a polishing time of approximately 40 to 100 seconds is sufficient to achieve the desired planarization.

In alternative, the planarization process can for example comprise a Reactive Ion Etching (RIE) process.

In this case, the desired planarization of the protective layer can be achieved by means of the complete etch back of sacrificial materials, like Spin-On-Glass (SOG) materials or photoresist, by way of Reactive Ion Etching. More particularly, after the protective layer 5 has been deposited, a film of SOG of thickness ranging from 0.4 to 1 µm is deposited over the protective layer; the SOG film is then completely etched away by means of reactive ion etching, and also the protection layer is partially etched away, so that a planar passivation layer can be obtained. The preferred process conditions are the following: for the reactive ion etching, a CF₄/CHF₃ chemistry is chosen, with a total gas flow of 100 to 300 sccm at a pressure of 100-400 mTorr; the plasma power ranges from 300 to 600 W.

After the planarization process, the chip is substantially as schematically depicted in Figure 2: the protection layer 5 has a substantially flat surface. This is advantageous because when the chip is encapsulated in a package (not shown), the interaction between the chip and the package is better, especially for ultra-thin packages (UTSOP): the mechanical stress exerted by the package on the chip is uniformly distributed over the entire (flat) surface of the final passivation layer, while if protrusions existed on the surface of the passivation layer as in Figure 1 the mechanical stress would be exerted over said protrusions, with the risk of craks in the passivation layer which acts as sites of penetration of aggressive agents and water molecules.

Figure 3 schematically shows a particularly advantageous application of the process according to the invention. In this figure, two integrated circuits chips 3' and 3'' are to be encapsulated in a same package to form a multi chip device. The chips can be formed in the same semiconductor wafer, so that they are not physically separated, or alternatively they can be physically separated chips that are mounted on a same common base of the package. The two chips will generally have substrates 4' and 4'' of different heights, depending for example on the number of different layers of material. As a consequence, if a conventional final passivation layer were to be formed over the multi chip structure, not only said passivation layer would have depressions and protrusions inside each single chip (due for example to gaps 1', 1'' between the underlying metal lines 2', 2''), but also the heigth of the passivation layer over the different chips would be different, due to the different thickness of the substrates.

According to the present invention, a protective layer 5 is formed over the whole multi chip device, and then the protective layer 5 is submitted to a planarization process. The planarization process not only allows for eliminating depressions and protrusions in the respective protection layer, thus obtaining a passivation layer having a substantially planar surface, but also allows for eliminating the difference in heigth of the passivation layer over the different chips: the top surface of the passivation layer 5 over the whole multichip structure will therefore be at the same heith H. This prevents that the mechanical stress of the package are exerted on only some chips of the multi chip device.

## Claims

1. A process of final passivation of an integrated circuit device comprising at least one integrated circuit chip, comprising a step of formation of a layer of protective material (5;5',5'') over a top surface of the at least one integrated circuit (3;3',3''), characterized by providing for a subsequent step of planarization of said layer of protective material (5;5',5'') to obtain a protection layer having a substantially flat top surface.

2. A process according to claim 1, characterized in that said step of planarization comprises a chemical mechanical polishing (CMP) of a top surface of the layer of protective material.

3. A process according to claim 1, characterized in that said step of planarization comprises a RIE etching of a top surface of the layer of protective material.

4. A process according to any one of the preceding claims, characterized in that said step of formation of the protective layer comprises a Chemical Vapor Deposition (CVD) of a protective material.

5. A process according to claim 4, characterized in that said step of formation of the protective layer comprises a first CVD of a first thickness of protective layer, followed by a partial etching of said first thickness of protective layer, and a second CVD of a second thickness of protective layer.

6. A process according to claim 4 or 5, characterized in that said CVD is a Plasma-Enhanced CVD (PECVD).

7. A process according to claim 4 or 5, characterized in that said CVD is performed at Atmosferic Pressure (APCVD).

8. A process according to claim 6 or 7, characterized in that said step of formation of the protective material comprises a High-Density Plasma Chemical Vapor Deposition (HDPCVD).

9. A process according to any one of the preceding claims, characterized in that said integrated circuit device comprises a plurality of said integrated circuit chips (3',3''), the process providing for the formation of a common protective material layer (5) over all the integrated circuit chips and the planarization of the common protective layer.
